Europäisches Patentamt

European Patent Office

Office européen des brevets

(11) Veröffentlichungsnummer: **0 489 259 A2**

# EUROPÄISCHE PATENTANMELDUNG

(21) Anmeldenummer: **91118659.1**

(51) Int. Cl.5: **G01R 27/26**

(22) Anmeldetag: **31.10.91**

(30) Priorität: **06.12.90 DE 4039006**

(43) Veröffentlichungstag der Anmeldung:
**10.06.92 Patentblatt 92/24**

(84) Benannte Vertragsstaaten:
**AT DE FR GB NL**

(71) Anmelder: **FRAUNHOFER-GESELLSCHAFT ZUR FÖRDERUNG DER ANGEWANDTEN FORSCHUNG E.V.**
**Leonrodstrasse 54**
**W-8000 München 19(DE)**

(72) Erfinder: **Wallrapp, Ludwig**
**Hollerweg 5**
**W-8520 Erlangen(DE)**
Erfinder: **Seitzer, Dieter**
**Humboldtstrasse 14**
**W-8520 Erlangen(DE)**

(74) Vertreter: **Schoppe, Fritz, Dipl.-Ing. et al**
**Seitnerstrasse 42**
**W-8023 Pullach bei München(DE)**

(54) **Kapazitäts-Frequenz-Wandler.**

(57) Eine Kapazitäts-Frequenz-Wandler zum Erzeugen eines im wesentlichen rechteckförmigen Wandlerausgangssignales mit einer von der Kapazität eines zu messenden Kondensators ($C_x$) abhängigen Pulswiederholfrequenz, bei dem Streukapazitäten insbesondere im Bereich der Zuleitungen zu der zu messenden Kapazität nur noch einen geringen Einfluß haben und bei dem die Meßgenauigkeit durch Schwankungen der Betriebsspannung des Kapazität-Frequenz-Wandlers nicht oder nur in geringem Maße beeinträchtigt wird, hat einen ersten Umschalter (S1), mit dem ein Pol des bezüglich seiner Kapazität zu messenden Kondensators ($C_x$) entweder gegen ein Bezugsspannungspotential oder gegen ein erstes Spannungspotential ($U_B$) schaltbar ist, einen zweiten Umschalter (S2), mit dem der andere Pol des Kondensators ($C_x$) entweder mit einem Knoten (KN) verbindbar oder gegen das Bezugsspannungspotential schaltbar ist, einen weiteren Kondensator ($C_I$), der einerseits mit dem Knoten (KN) und andererseits mit einem zweiten Spannungspotential verbunden ist, eine mit dem Knoten (KN) verbundene Stromquelleneinrichtung (R*; R1, R2, R3, K2, T), einen Komparator (K1), dessen erster Eingang mit dem Knoten (KN), dessen zweiter Eingang mit dem Bezugsspannungspotential verbunden ist und dessen Ausgang das Wandlerausgangssignal liefert, eine an den Ausgang des Komparators (K1) angeschlossene Pulserzeugungsschaltung (P) zum Erzeugen je eines Pulses von vorgegebener Dauer (T) bei Auftreten einer Flanke des im wesentlichen rechteckförmigen Wandlerausgangssignales, deren Ausgang mit den den Schaltzustand steuernden Eingängen des ersten und zweiten Umschalters (S1, S2) verbunden ist.

FIG.1

Die vorliegende Erfindung betrifft einen Kapazitäts-Frequenz-Wandler zum Erzeugen eines im wesentlichen rechteckförmigen Wandlerausgangssignales mit einer von der Kapazität eines zu messenden Kondensators abhängigen Frequenz, gemäß dem Oberbegriff der Patentansprüche 1 und 18.

Aus dem Standardfachbuch Tietze, Schenk, Halbleiter-Schaltungstechnik, 9. Auflage, 1989, Seite 925 ist bereits ein Kapazitäts-Spannungs-Wandler bekannt. Um diesen Kapazitäts-Spannungs-Wandler zu einem Kapazitäts-Frequenz-Wandler zu erweitern, bedarf es eines zusätzlichen Spannungs-Frequenz-Wandlers. Die Ausgangsspannung des bekannten Kapazitäts-Spannungs-Wandlers ist von der Eingangsbezugsspannung abhängig, so daß Schwankungen der Eingangsbezugsspannung zu entsprechenden Meßfehlern führen. Streukapazitäten, die am Eingang des bekannten Kapazitäts-Spannungs-Wandlers parallel zu der zu messenden Kapazität nach Masse liegen, gehen in die Ausgangsspannung direkt ein. Das führt dazu, daß der bekannte Kapazitäts-Spannungs-Wandler nur für solche Anwendungsfälle bei hinnehmbar niedrigen Meßfehlern einsetzbar ist, bei denen aufgrund von kurzen Zuleitungen zu der zu messenden Kapazität nur niedrige Streukapazitäten auftreten oder bei denen die zu messende Kapazität einen hohen Wert hat.

Aus dem Datenbuch für Halbleiterschaltungen: Linear Databook 1990 der Firma Linear Technology Corporation, Seite 11 bis 23, rechte Abbildung oben ist ein Spannungs-Frequenz-Wandler bekannt, der eine geschaltete Kapazität zwischen dem Ausgang und dem invertierenden Eingang eines Operationsverstärkers aufweist, wobei der nicht-invertierende Eingang einerseits über einen Widerstand mit Masse und andererseits über eine weitere Kapazität mit dem Ausgang verbunden ist und wobei ferner der invertierende Eingang über den Emitter eines Transistors mit einer negativen Bezugsspannung verbunden ist, dessen Basis an dem gemeinsamen Knoten einer Reihenschaltung eines weiteren Widerstandes und eines weiteren Kondensators anliegt, wobei diese Reihenschaltung zwischen dem Ausgang des Operationsverstärkers und Masse liegt. Es ist zwar denkbar, bei einem derartigen Spannungs-Frequenz-Wandler die geschaltete Kapazität durch eine Kapazität zu ersetzen, deren Kapazitätswert zu bestimmen ist und somit bei fester Eingangsspannung diese Schaltung als Kapazitäts-Frequenz-Wandler einzusetzen. Jedoch wäre auch bei einer derartigen Abwandlung der bekannten Schaltung eine Streukapazität gegen Masse in Parallelschaltung zu der zu messenden Kapazität. Ferner wären zwei Bezugsspannungen erforderlich, deren eventuelle Variationen direkt in die Ausgangsfrequenz und somit in die erzielbare Meßgenauigkeit eingehen würden.

Aus der US 4,054,833 A ist bereits eine Kapazitätsmeßschaltung bekannt, die einen Meßkondensator, einen in Reihe zu diesem geschalteten Bezugskondensator und Schalter zum anschalten der Reihenschaltung aus diesen Kondensatoren an unterschiedliche Potentiale aufweist, wobei der gemeinsame Knoten der Reihenschaltung der beiden Kondensatoren über ein Rückkopplungsnetzwerk zu einem Steuereingang für die beiden Schalter rückgeführt wird. Auch bei dieser Kapazitätsmeßschaltung wird die erzielbare Meßgenauigkeit durch Streukapazitäten beeinflußt, die parallel zu der zu messenden Kapazität gegen Masse liegen.

Aus der US 4,794,320 ist eine weitere Kapazitätsmeßschaltung bekannt, bei der zwei Kondensatoren als frequenzbestimmendes Element in der Weise sequentiell an eine Oszillatorschaltung angeschaltet werden, daß zunächst ein Kondensator, sodann der andere Kondensator, sodann beide Kondensatoren und zuletzt keiner der beiden Kondensatoren an den Oszillator angeschaltet werden. Durch geeignete Subtraktion, Multiplikation und Quotientenbildung der sich ergebenden Kondensatorausgangsfrequenzen wird das Kapazitätsverhältnis der beiden Kondensatoren gemessen. Auch bei dieser Kapazitätsmeßschaltung ergeben sich die eingangs erläuterten Meßungenauigkeiten.

Ausgehend von diesem Stand der Technik liegt der vorliegenden Erfindung die Aufgabe zugrunde, einen Kapazitäts-Frequenz-Wandler der eingangs genannten Art zu schaffen, bei dem Streukapazitäten insbesondere im Bereich der Zuleitungen zu der zu messenden Kapazität nur noch einen geringen Einfluß haben und bei der die Meßgenauigkeit durch Schwankungen der Betriebsspannung des Kapazität-Frequenz-Wandlers nicht oder nur in geringem Maße beeinträchtigt wird.

Diese Aufgabe wird durch einen Kapazitäts-Frequenz-Wandler gemäß Patentanspruch 1 gelöst.

In der Sensorik tritt häufig der Fall auf, daß sich eine Kapazität, die einen physikalischen Wert entspricht, über einen kleinen Bereich ihrer Gesamtkapazität ändert, während sich der zu erfassende physikalische Wert über einen großen Bereich geändert hat. In einem derartigen Fall kann der Kapazitäts-Frequenz-Wandler nur dann eine erhöhte Meßgenauigkeit des physikalischen Wertes liefern, wenn eine erhöhte Genauigkeit in der Messung der Ausgangsfrequenz erreicht wird.

Daher liegt der vorliegenden Erfindung die weitere Aufgabe zugrunde, einen Kapazitäts-Frequenz-Wandler zu schaffen, bei dem einerseits Streukapazitäten insbesondere im Bereich der Zuleitungen der zu messenden Kapazität nur einen geringen Einfluß haben und bei der die Meßgenauigkeit durch Schwankungen der Betriebsspannung des Kapazitäts-Frequenz-Wandlers nur in geringem Maße beeinträchtigt wird und bei dem andererseits eine genauere Messung von kleinen Kapazitätsänderungen erreicht wird.

Diese Aufgabe wird durch einen Kapazitäts-Frequenz-Wandler gemäß den Patentansprüchen 8 und 11 gelöst.

Bei der Kapazitäts-Frequenz-Wandlerschaltung wird der bezüglich seiner Kapazität zu messende Kondensator mit einer Meßspannung beaufschlagt, die einen gewissen Gleichanteil aufweist. In einigen Anwendungsfällen ist dies unerwünscht.

Im Falle von kapazitiven Feuchtsensoren darf die Meßspannung keinen Gleichanteil über längere Zeit aufweisen, da dieser zur Zerstörung des Sensors führen würde.

Daher liegt der Erfindung die weitere Aufgabe zugrunde, einen Kapazitäts-Frequenz-Wandler der eingangs genannten Art zu schaffen, bei dem einerseits Streukapazitäten insbesondere im Bereich der Zuleitungen der zu messenden Kapazität nur einen geringen Einfluß haben und bei dem andererseits eine von Gleichspannungsanteilen zumindest weitgehend befreite Messung erreicht wird.

Diese Aufgabe wird durch einen Kapazitäts-Frequenz-Wandler gemäß Patentanspruch 18 gelöst.

Bevorzugte Weiterbildungen des erfindungsgemäßen Kapazitäts-Frequenz-Wandlers sind in den Unteransprüchen angegeben.

Nachfolgend werden unter Bezugnahme auf die beiliegenden Zeichnungen bevorzugte Ausführungsbeispiele des erfindungsgemäßen Kapazitäts-Frequenz-Wandlers näher erläutert. Es zeigen:

Fig. 1    ein erstes Ausführungsbeispiel des Kapazitäts-Frequenz-Wandlers;

Fig. 2    ein zweites Ausführungsbeispiel des Kapazitäts-Frequenz-Wandlers;

Fig. 3    ein drittes Ausführungsbeispiel des Kapazitäts-Frequenz-Wandlers;

Fig. 4    ein viertes Ausführungsbeispiel des Kapazitäts-Frequenz- Wandlers:

Fig. 5    ein alternatives, fünftes Ausführungsbeispiel des Kapazitäts-Frequenz-Wandlers;

Fig. 6    eine sechste Ausgestaltung des in Fig. 4 gezeigten Kapazitäts-Frequenz-Wandlers für mehrere bezüglich ihrer Kapazität zu messende Kondensatoren;

Fig. 7    eine siebte Ausgestaltung der in Fig. 5 gezeigten Ausführungsform des Kapazitäts-Frequenz-Wandlers, ebenfalls für mehrere bezüglich ihrer Kapazität zu messende Kondensatoren;

Fig. 8    ein achtes Ausführungsbeispiel des Kapazitäts-Frequenz-Wandlers;

Fig. 9    eine zeitliche Darstellung der Signalverläufe innerhalb des achten Ausführungsbeispiels des erfindungsgemäßen Kapazitäts-Frequenz- Wandlers; und

Fig. 10   eine neunte Ausgestaltung des Kapazitäts-Frequenz-Wandlers.

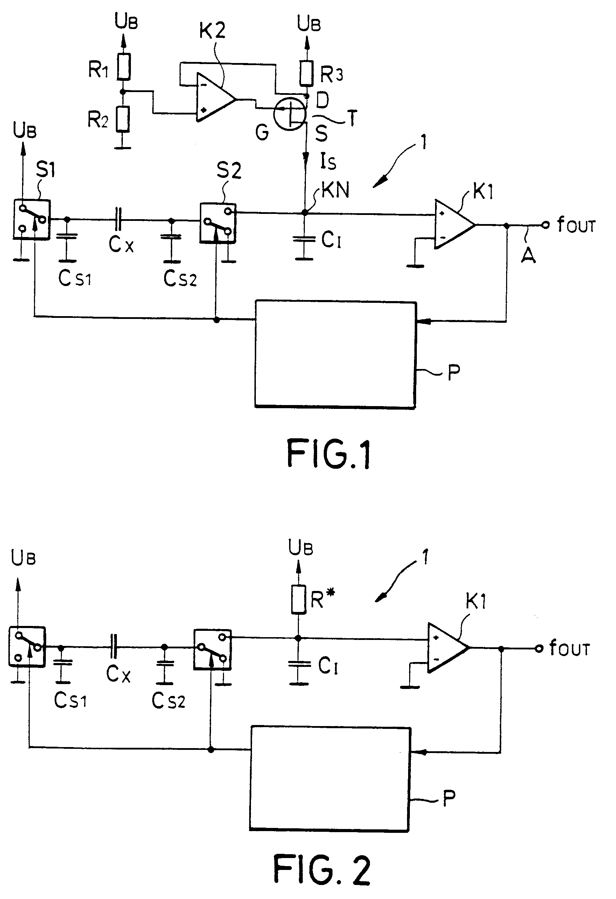

Wie in Fig. 1 gezeigt ist, umfaßt der Kapazitäts-Frequenz-Wandler, der in seiner Gesamtheit mit dem Bezugszeichen 1 bezeichnet ist, einen ersten Umschalter S1, der mit einem ersten Pol eines bezüglich seiner Kapazität zu messenden Kondensators $C_x$ verbunden ist und diesen in einem ersten Schaltzustand mit Masse verbindet oder in einem zweiten Schaltzustand, der in der Figur dargestellt ist, mit einer Betriebsspannung $U_B$ verbindet. Der zweite Pol des bezüglich seiner Kapazität zu messenden Kondensators $C_x$ ist mit einem zweiten Umschalter S2 verbunden, der diesen in einem ersten Schaltzustand mit einem Knoten KN des Kapazitäts-Frequenz-Wandlers 1 oder in einem zweiten (hier dargestellten) Zustand mit Masse verbindet. Beide Pole bzw. Anschlüsse des bezüglich seiner Kapazität zu messenden Kondensators $C_x$ weisen Streukapazitäten $C_{S1}$, $C_{S2}$ gegen Masse auf. Bei den Streukapazitäten kann es sich beispielsweise um die Kapazitäten von Anschlußleitungen handeln, die insbesondere dann einen hohen Wert aufweisen können, wenn der Kondensator mit der zu messenden Kapazität $C_x$ über eine weite Strecke von dem Kapazitäts-Frequenz-Wandler beabstandet ist und an diesen über Koaxialleitungen angeschlossen ist. Ein weiterer Kondensator $C_I$ liegt zwischen dem Knoten KN und Masse. Der Knoten KN ist an eine spannungsgesteuerte Stromquelle R1, R2, K2, R3, T angeschlossen, die den Knoten mit einem konstanten Strom beaufschlagt, wie dies nachfolgend noch erläutert werden wird.

Der Kapazitäts-Frequenz-Wandler 1 umfaßt ferner einen Komparator K1, dessen nicht-invertierender Eingang mit dem Knoten KN und dessen invertierender Eingang mit Masse verbunden ist. Der Ausgang dieses Komparators K1 bildet den Ausgang des Kapazitäts-Frequenz-Wandlers, welcher ein im wesentlichen rechteckförmiges Wandlerausgangssignal hat, dessen Frequenz $f_{out}$ umgekehrt proportional zu der Kapazität des zu messenden Kondensators ist.

Der Wandlerausgang A ist mit dem Eingang einer Pulserzeugungsschaltung P verbunden, die zum Erzeugen je eines Impulses von vorgegebener Dauer T bei Auftreten je einer fallenden oder steigenden Flanke des im wesentlichen rechteckförmigen Wandlerausgangssignales dient.

Bei der Pulserzeugungsschaltung P, die an sich im Stand der Technik bekannt ist, kann es sich entweder um eine analog aufgebaute oder digital aufgebaute Schaltung handeln. Bei vielen Anwendungsfällen des Kapazitäts-Frequenz-Wandlers wird es möglich sein, sich eines Taktsignales zu bedienen, dessen Taktfrequenz zur Ansteuerung einer digital aufgebauten Pulserzeugungsschaltung verwendet werden kann.

Der Ausgang der Pulserzeugungsschaltung dient dazu, den ersten Umschalter S1 sowie den zweiten Umschalter S2 in den ersten bzw. zweiten Schaltzustand zu bringen.

Die spannungsgesteuerte Stromquelle, die mit dem Knoten KN verbunden ist, umfaßt einen n-Kanal-Feldeffekttransistor T, dessen Sourceelektrode mit dem Knoten KN verbunden ist und dessen Drainelektrode über einen dritten Widerstand R3 mit der Betriebsspannung $U_B$ verbunden ist. Die Drainelektrode des Feldeffekttransistors T ist mit dem invertierenden Eingang eines Operationsverstärkers K2 verbunden, dessen nicht-invertierender Eingang mit dem gemeinsamen Knoten eines durch zwei Widerstände R1, R2 gebildeten Spannungsteilers verbunden ist. Der Spannungsteiler ist einerseits gegen Masse und andererseits gegen die Betriebsspannung $U_B$ geschaltet.

Der von der spannungsgesteuerten Stromquelle R1, R2, R3, T, K2 abgegebene Strom $I_S$ kann folgendermaßen in Abhängigkeit von der Betriebsspannung $U_B$ und von den Widerstandswerten des ersten bis dritten Widerstandes R1, R2, R3 ausgedrückt werden:

$$(1) \quad I_S = \frac{U_{R3}}{R3} = \frac{1}{R3} \left( U_B - \frac{R2}{R1 + R2} \cdot U_B \right) \ ;$$

$$(2) \quad I_S = \frac{U_B}{R^*} \ ; \quad R^* = \frac{R3 \ (R1 + R2)}{R1} \ ;$$

Nachfolgend wird die Betriebsweise der oben beschriebenen Schaltung näher erläutert. Es sei angenommen, daß das Potential an dem weiteren Kondensator $C_I$ ansteigt und soeben das Bezugspotential des Komparators K1 in Richtung auf die Betriebsspannung $U_B$ ansteigend durchläuft. Der Komparator K1 schaltet, woraufhin die Pulserzeugungsschaltung P während einer vorgegebenen Zeitdauer T die beiden Umschalter S1, S2 in den zweiten Schaltzustand, welcher in Fig. 1 dargestellt ist, setzt. In diesem Schaltzustand wird der bezüglich seiner Kapazität zu messende Kondensator $C_x$ auf die Betriebsspannung $U_B$ aufgeladen. Nach Ablauf dieser Zeit nehmen die beiden Umschalter S1, S2 den ersten Schaltzustand ein, welcher entgegengesetzt zu dem in Fig. 1 gezeigten Schaltzustand ist. In diesem Schaltzustand gibt der zu messende Kondensator $C_x$ seine Ladung Q an den weiteren Kondensator $C_I$ ab, so daß dessen Potential in die der Betriebsspannung entgegengesetzten Spannungsrichtung springt, wodurch der Komparator K1 wieder in seine Ausgangsstellung zurückfällt, woraufhin der weitere Kondensator $C_I$ und der bezüglich seiner Kapazität zu messende Kondensator $C_x$ über die Stromquelleneinrichtung T, R1 bis R3, K2 in Richtung auf die Betriebsspannung $U_B$ hin entladen werden. Sobald das Potential am Knoten KN das Bezugspotential des Komparators K1 in Richtung auf die Betriebsspannung $U_B$ hin durchläuft, wiederholt sich der oben beschriebene Vorgang.

Die Ausgangsfrequenz der Schaltung ergibt sich aus der Schwingungsbedingung für die Schaltung, die wiederum erfordert, daß die der Stromquelleneinrichtung T, R1, R2, R3, K2 zugeführte Ladung derjenigen Ladung gleicht, die dem Knotenpunkt KN über den bezüglich seiner Kapazität zu messenden Kondensator $C_x$ zugeführt wird. Hieraus ergibt sich folgende Gleichung:

$$(3) \quad C_x \cdot U_B = \frac{U_B}{R^*} \cdot \frac{1}{f_{out}}$$

Wie man erkennt, fällt bei diesem Zusammenhang die Abhängigkeit von der Betriebsspannung $U_B$ heraus, so daß folgende Gleichung für die Ausgangsfrequenz gilt:

$$(4) \qquad f_{out} \quad = \quad \frac{1}{R^* \cdot C_x}$$

Die nachfolgende Betrachtung wird zeigen, daß auch die Einflüsse von Streukapazitäten zumindest weitgehend herausfallen.

Soweit die erste Streukapazität $C_{S1}$ betroffen ist, wird diese über den ersten Umschalter S1 entweder auf die Betriebsspannung $U_B$ geladen oder auf das Bezugspotential entladen. Unter der üblicherweise erfüllten Voraussetzung, daß der Durchgangswiderstand des ersten Umschalters S1 entsprechend niedrig ist, wird der bezüglich seiner Kapazität $C_x$ zu messende Kondensator innerhalb der Impulsbreite T, die von der Pulserzeugungsschaltung P festgelegt wird, trotz der ersten Streukapazität $C_{S1}$ auf die Betriebsspannung $U_B$ aufgeladen. Damit hat die erste Streukapazität keinen Einfluß auf die Messung des bezüglich seiner Kapazität zu messenden Kondensators $C_x$.

Soweit die zweite Streukapazität $C_{S2}$ betroffen ist, so wird diese mit dem weiteren Kondensator $C_I$ von dem bezüglich seiner Kapazität $C_x$ zu messenden Kondensator einerseits geladen und andererseits über den wirksamen Widerstand $R^*$ der Stromquelleneinrichtung entladen. Solange sichergestellt ist, daß der Komparator K1 schaltet, sobald die Spannung an dem Knoten KN das Bezugspotential durchläuft, ist die zweite Streukapazität $C_{S2}$ zum Schaltzeitpunkt vollständig entladen, so daß sie gleichfalls keinen Einfluß mehr auf die Bestimmung des Kapazitätswertes des zu messenden Kondensators $C_x$ hat.

Aus diesem Grunde kann bei dem Kapazitäts-Frequenz-Wandler 1 der bezüglich seines Kapazitätswertes zu messende Kondensator $C_x$ weit vom Meßort entfernt angeordnet sein. Insbesondere ist es möglich, den Anschluß dieses Kondensators über Koaxialkabel vorzunehmen, deren Abschirmung auf Bezugspotential liegt und deren Innenleiter den bezüglich seiner Kapazität zu messenden Kondensator $C_x$ und den zweiten Umschalter S2 verbindet.

Fig. 2 zeigt eine vereinfachte Ausführungsform der in Fig. 1 gezeigten Schaltung, derer man sich bedienen kann, wenn man lediglich die Kapazitätswerte von kleinen Kondensatoren $C_x$ bestimmen will. In diesem Fall wird die Stromquelleneinrichtung gemäß Fig. 1 durch einen Widerstand $R^*$ ersetzt. Voraussetzung hierfür ist, daß die Kapazität des weiteren Kondensators $C_I$ sehr viel größer ist als diejenige des zu messenden Kondensators $C_x$.

Falls die letztgenannte Bedingung erfüllt ist, ist die maximale Spannung $U_{CImax}$ nach Parallelschaltung des zu messenden Kondensators $C_x$ und des weiteren Kondensators $C_I$ sehr viel kleiner als die Betriebsspannung $U_B$. Die an dem weiteren Kondensator $C_I$ maximal auftretende Spannung läßt sich daher folgendermaßen ausdrücken:

$$(5) \qquad U_{CImax} \quad = \quad \frac{C_x}{C_x + C_I} \cdot U_B$$

Die mittlere Entladespannung $U_{CImittel}$ an dem weiteren Kondensator $C_I$ kann folgendermaßen ausgedrückt werden:

$$(6) \qquad U_{CImittel} \quad \approx \quad \frac{1}{2} \cdot \frac{C_x}{C_x + C_I} \cdot U_B$$

Der über eine Periode gemittelte Strom $I_{Rmittel}$ durch den Widerstand $R^*$ kann folgendermaßen ausgedrückt werden:

$$(7) \quad I_{Rmittel} = \frac{U_B + U_{CImittel}}{R^*} \approx \frac{U_B}{R^*}\left(1 + \frac{C_x}{2\ (C_x + C_I)}\right)$$

Aus der siebten Gleichung ist es ersichtlich, daß für Kapazitätswerte des weiteren Kondensators $C_I$, die viel größer als der Kapazitätswert des zu messenden Kondensators sind, folgende Gleichung gilt:

$$(8) \quad f_{out} \approx \frac{1}{R^* \cdot C_x}$$

Obwohl die obige Gleichung für besonders hohe Werte der Kapazität des weiteren Kondensators $C_I$ besonders gut erfüllt wird, ist es dennoch nicht möglich, beliebig hohe Kapazitätswerte des weiteren Kondensators $C_I$ zu wählen. Die Dimensionierung des weiteren Kondensators $C_I$ muß unter Berücksichtigung der Eigenschaften des Komparators K1 erfolgen, der als reale Schaltung für abnehmende Eingangsspannungsänderungen zunehmende Schaltzeiten für das Umschalten des Ausgangssignales zeigt.

Unter Berücksichtigung dieser Eigenschaften des Komparators K1 wird man jedoch bemüht sein, den Kapazitätswert des weiteren Kondensators $C_I$ so groß als möglich zu wählen, um auch eventuelle parasitäre Ströme, die zum Bezugspotential hin abfließen, zu verringern. In erster Näherung können diese folgendermaßen ausgedrückt werden:

$$(9) \quad I_{parasitär} = \frac{U_{CImittel}}{R_{parasitär}}$$

$$\approx \frac{U_B}{R_{parasitär}} \cdot \frac{C_x}{2\ (C_x + C_I)}$$

Hieraus ergibt sich, daß die Einflüsse parasitärer Widerstände mit ansteigendem Kapazitätswert des weiteren Kondensators $C_I$ abnehmen.

Bei geeignet hoher Wahl des Kapazitätswertes des weiteren Kondensators $C_I$ ermöglicht somit der erfindungsgemäße Kapazitäts-Frequenz-Wandler 1 die Messung von Kapazitäten $C_x$ mit schlechter Güte, wie dies z. B. bei kapazitiven Feuchtesensoren der Fall ist.

Das Ersatzschaltbild eines Kondensators schlechter Güte entspricht einem idealen Kondensator mit parallel geschaltetem Widerstand. Dieser Widerstand $R_{parasitär}$ ist zum Bezugspotential hin wirksam, solange während der Entladephase der erfindungsgemäßen Kapazitäts-Frequenz-Wandlerschaltung der bezüglich seiner Kapazität zu messende Kondensator $C_x$ parallel zu dem weiteren Kondensator $C_I$ geschaltet ist.

Die Schaltung gemäß Fig. 2 ist verglichen mit der Schaltung nach Fig. 1 dahingehend vorteilhafter, daß sie einfacher, billiger und temperaturstabiler ist, bezüglich der Alterung stabiler ist und breitbandiger arbeitet.

Die in Fig. 2 gezeigte Schaltung ist andererseits gegenüber der in Fig. 1 gezeigten Schaltung dahingehend nachteilig, daß die Ausgangsfrequenz eine geringe Abhängigkeit von der Betriebsspannung $U_B$ aufweist, da der Kapazitätswert des weiteren Kondensators $C_I$ nicht unendlich groß gewählt werden kann. Bei Verwendung eines einfachen Spannungsreglers für die Betriebsspannung $U_B$ kann jedoch die Ausgangsfrequenz als allein von dem zu messenden Kapazitätswert $C_x$ abhängig angesehen werden.

Ferner hat die Schaltung gemäß Fig. 2 eine gewisse Nicht-Linearität der Ausgangsfrequenz in Abhängigkeit vom Kapazitätswert des zu messenden Kondensators $C_x$ sowie dem Kapazitätswert des weiteren Kondensators $C_I$, wie dies bereits beschrieben wurde. Falls das durch die Schaltung erzielte Ausmaß an Linearität unzureichend ist, kann die Schaltung durch eine Eichung gemäß der obigen Berechnung von Linearitätsfehlern befreit werden.

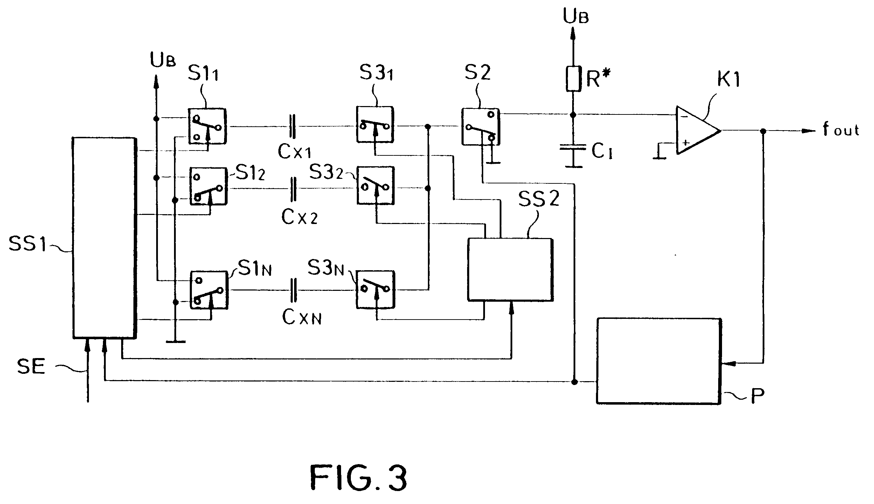

Die in Fig. 3 gezeigte Schaltung stimmt mit Ausnahme der nachfolgend erläuterten Abweichungen mit der Schaltung gemäß Fig. 2 überein. Jedoch dient diese zur Messung der Kapazität von einer Mehrzahl N von zu messenden Kondensatoren $C_{x1}$, $C_{x2}$, ..., $C_{S2}$. Eine entsprechende Mehrzahl N von ersten Schaltern $S1_1$, ....., $S1_N$ ist je einem der zu messenden Kondensatoren $C_{x1}$, ..., $C_{xN}$ zugeordnet. Zwischen dem zweiten Umschalter und dem anderen Pol eines jeden der zu messenden Kondensatoren $C_{x1}$, ..., $C_{xN}$ liegt jeweils ein Schalter aus einer entsprechenden Mehrzahl N von dritten Schaltern $S3_1$, ..., $S3_N$.

Eine Schaltersteuerung SS1, SS2, welche von einem Schalteingang SE zur Auswahl des zu messenden Kondensators $C_{x1}$, ..., $C_{xN}$ angesteuert wird, aktiviert einen der ersten Umschalter $S1_1$, ..., $S1_N$ in Abhängigkeit vom Ausgangssignal der Pulserzeugungsschaltung P und schaltet die übrigen ersten Umschalter in ihren ersten Schaltzustand. Ferner schließt die Schaltersteuerung den entsprechenden dritten Schalter $S3_1$, ..., $S3_N$ und öffnet alle übrigen der dritten Schalter $S3_1$, ..., $S3_N$.

Soweit nur Kapazitäten $C_{x1}$, ..., $C_{xN}$ mit hoher Güte gemessen werden, können die dritten Schalter $S3_1$, ..., $S3_N$ entfallen, da die nicht interessierenden Kapazitäten bezüglich der zu messenden Kapazität lediglich als Streukapazitäten wirken, die nicht in die Ausgangsspannung eingehen.

Soweit nicht nur Kondensatoren mit hoher Güte, sondern auch solche mit schlechter Güte gemessen werden sollen, ist es vorteilhaft, von den dritten Schaltern $S3_1$, ..., $S3_N$ Gebrauch zu machen, da sie das Fließen parasitärer Ströme über die nicht zu messenden Kapazitäten $C_{x1}$, ..., $C_{xN}$ verhindern.

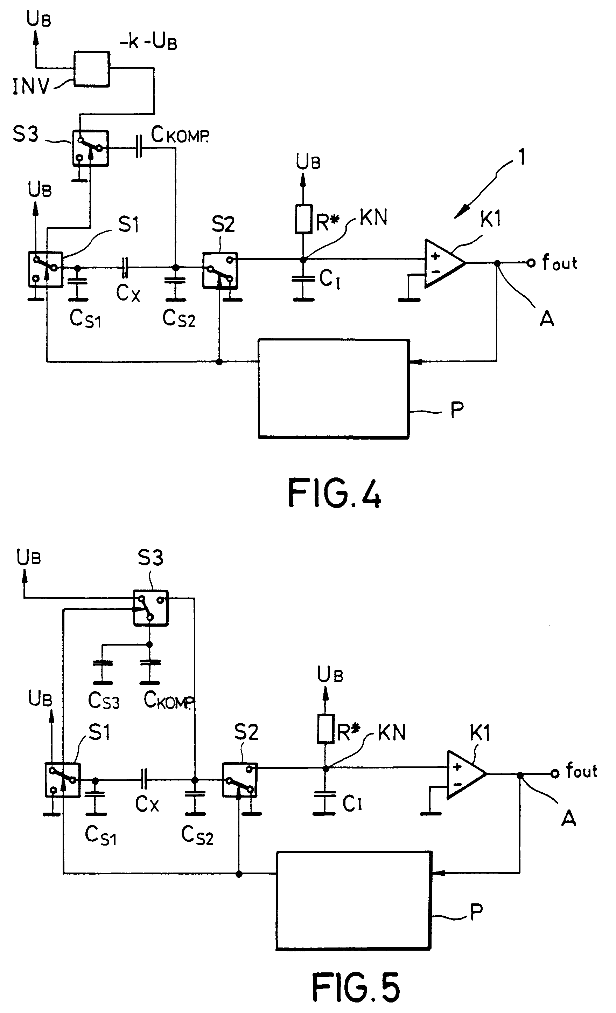

Fig. 4 zeigt eine Abwandlung der Ausführungsform des erfindungsgemäßen Kapazitäts-Frequenz-Wandlers nach Fig. 2 mit einer Kapazitäts-Offset-Kompensation. Diejenigen Schaltungsteile, die mit gleichen Bezugszeichen bezeichnet sind, stimmen mit der Schaltung nach Fig. 2 überein, so daß auf deren erneute Erläuterung verzichtet werden kann.

Die in Fig. 4 gezeigte Kapazitäts-Frequenz-Wandlerschaltung, die in ihrer Gesamtheit mit dem Bezugszeichen 1 bezeichnet ist, umfaßt zusätzlich zu der Schaltung gemäß Fig. 2 einen Kompensationskondensator $C_{komp}$, einen dritten Umschalter S3 sowie einen Inverter INV. Der Kompensationskondensator $C_{komp}$ ist mit einem Pol mit dem anderen Pol des bezüglich seiner Kapazität zu messenden Kondensators $C_x$ verbunden. Der andere Pol des Kompensationskondensators $C_{komp}$ ist über den dritten Umschalter S3 entweder in einem ersten Schaltzustand gegen Masse oder in einem zweiten Schaltzustand gegenüber einem ausgangsseitigen Potential des Inverters INV schaltbar. Bei diesem ausgangsseitigen Potential - k $\cdot$ $U_B$ handelt es sich um ein Potential, das proportional zu der Betriebsspannung $U_B$ und invers zu dieser ist.

Nachfolgend wird die Funktionsweise dieser Schaltung insoweit erläutert, als sie sich von der Funktionsweise der Schaltung gemäß Fig. 2 unterscheidet. In dem gezeigten zweiten Schaltzustand findet die Ladephase des zu messenden Kondensators $C_x$ sowie des Kompensationskondensators $C_{komp}$ statt. Werden der erste, zweite und dritte Umschalter durch eine Schaltersteuerung, die durch die Pulserzeugungsschaltung P bewirkt sein kann, in den nicht gezeigten ersten Schaltzustand gebracht, so wird der weitere Kondensator $C_I$ nur noch mit der Differenz der Ladungen von dem zu messenden Kondensator $C_x$ und dem Kompensationskondensator $C_{komp}$ beaufschlagt, womit auch die Ausgangsfrequenz $f_{out}$ nur noch von der Differenz der Ladungen abhängt.

Auch für die in Fig. 4 gezeigte Schaltung gelten die Gleichungen (1) und (2).

Aus den Schwingbedingungen für diese Schaltung folgen jedoch die nachfolgend aufgeführten, leicht veränderten Zusammenhänge:

$$(3a) \quad Q_{cx} - Q_{komp} = \frac{U_B}{R^*} \cdot \frac{1}{f_{out}}$$

$$(3b) \quad C_x \cdot U_B - K \cdot C_{komp} \cdot U_B = \frac{U_B}{R^*} \cdot \frac{1}{f_{out}}$$

Hieraus folgt:

$$(3c) \quad \Delta C_x \cdot U_B = \frac{U_B}{R^*} \cdot \frac{1}{f_{out}}$$

$$\text{mit}$$

$$(3d) \quad \Delta C_x = C_x - K \cdot C_{komp}$$

$$(4a) \quad f_{out} = \frac{1}{R^* \cdot \Delta C_x}$$

Daher gelten für die Schaltung gemäß Fig. 4 bezüglich der differentiellen Meßkapazität $C_x$ diejenigen Zusammenhänge, die bei der Schaltung gemäß Fig. 2 für die Meßkapazität $C_x$ selbst gelten.

Für die Streukapazitäten $C_{S1}$, $C_{S2}$ gilt gleichfalls das unter Bezugnahme auf Fig. 2 erläuterte.

An der Kompensationskapazität $C_{komp}$ können entsprechende Streukapazitäten anliegen. Da die Ansteuerung der Kompensationskapazität $C_{komp}$ und deren Beschaltung der Ansteuerung und der Beschaltung der Meßkapazität $C_x$ entsprechen, wirken sich auch hier die Streukapazitäten nicht auf die Ausgangsfrequenz der Schaltung aus. Daher kann auch die Kompensationskapazität $C_{komp}$ ebenso wie die Meßkapazität beispielsweise über ein Koaxialkabel angeschlossen werden und sich entfernt von der Schaltung befinden, ohne daß dies die Funktionsweise der Schaltung beeinträchtigen würde.

Fig. 5 zeigt eine Abwandlung der Ausführungsform gemäß Fig. 4. Bei dieser Ausgestaltung ist der Kompensationskondensator $C_{komp}$ mit seinem einen Pol gegen Masse geschaltet, während der andere Pol mittels des dritten Umschalters S3 entweder in einem ersten Schaltzustand mit dem anderen Pol des Kondensators $C_x$ oder in einem zweiten Schaltzustand mit der Betriebsspannung $U_B$ verbindbar ist. Die in Fig. 4 gezeigte Inverterschaltung INV entfällt.

Die in Gleichung (3d) angegebene Konstante k ist bei dieser Schaltung 1.

Bezüglich der Funktionsweise stimmt die in Fig. 5 gezeigte Schaltung mit Ausnahme ihres Verhaltens bezüglich der Streukapazität des Kompensationskondensators $C_{komp}$ vollständig mit der in Fig. 4 gezeigten Schaltung überein.

In Fig. 5 wurde eine weitere Streukapazität $C_{S3}$ des Kompensationskondensators $C_{komp}$ dargestellt. Bezüglich dieser Streukapazität ist die Schaltung nach Fig. 5 gegenüber der Schaltung von Fig. 4 nachteilig, da, wie erläutert, die Schaltung gemäß Fig. 4 auch gegenüber Streukapazitäten des Kompensationskondensators unempfindlich ist.

Daher kommt die Schaltung gemäß Fig. 5 in Betracht, wenn es nicht auf den Absolutbetrag der Kompensationskapazität $C_{komp}$ ankommt und wenn sichergestellt ist, daß sich die Streukapazität $C_{S3}$ nicht zeitabhängig ändert.

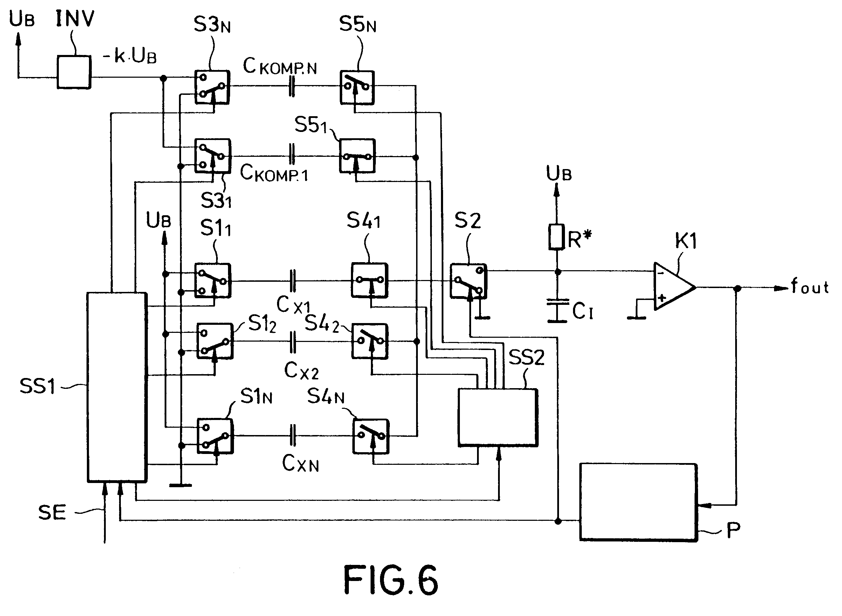

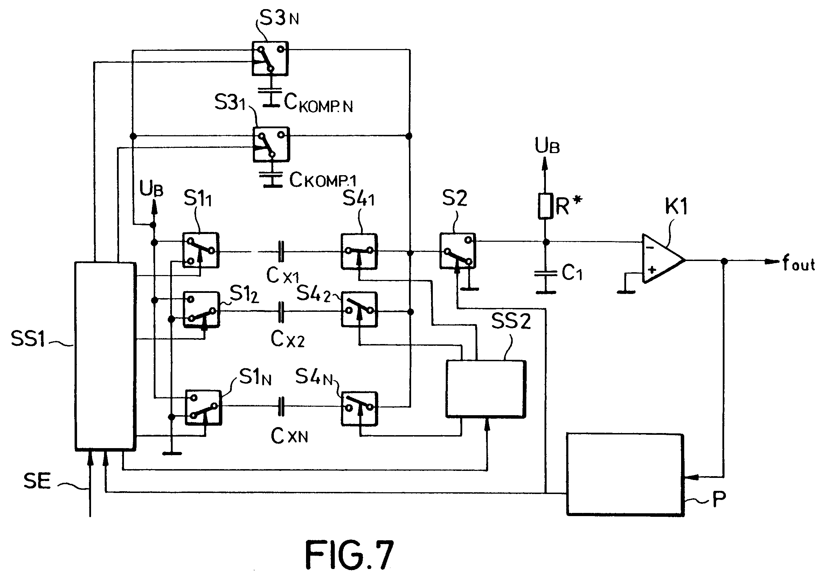

Die Schaltungen nach den Fig. 6 und 7 zeigen die Anwendung des Kapazitäts-Frequenz-Wandlers mit Kapazitäts-Offset-Kompensation nach den Fig. 4 und 5 auf die in Fig. 3 gezeigte Kapazitäts-Frequenz-Wandlerschaltung mit einer Vielzahl von bezüglich ihres Kapazitätswertes zu messenden Kondensatoren $C_{x1}$ bis $C_{xN}$. Bezüglich der Grundstruktur stimmen daher die Schaltungen nach den Fig. 6 und 7 mit derjenigen gemäß Fig. 3 überein. Es sind lediglich die in Fig. 3 als dritte Schalter $S3_1$ bis $S3_N$ bezeichneten Schalter in den Fig. 6 und 7 als vierte Schalter $S4_1$ bis $S4_N$ bezeichnet. Die Schaltung gemäß Fig. 6 hat somit eine Mehrzahl N von bezüglich ihrer Kapazität zu messenden Kondensatoren $C_{x1}$, ..., $C_{xN}$, eine entsprechende Mehrzahl von ersten Umschaltern $S1_1$, ..., $S1_N$, die mit diesen Kondensatoren verbunden sind, eine entsprechende Mehrzahl von vierten Schaltern $S4_1$, ..., $S4_N$ zwischen den Kondensatoren $C_{x1}$, ..., $C_{xN}$ und dem zweiten Umschalter S2, sowie eine entsprechende Mehrzahl N von Kompensationskondensatoren $C_{komp1}$ bis $C_{kompN}$. Insoweit ist die Schaltung gemäß Fig. 6 identisch zu derjenigen gemäß Fig. 7.

8

Bei der Schaltung gemäß Fig. 6 ist eine entsprechende Mehrzahl N von dritten Umschaltern $S3_1$, ..., $S3_N$ vorgesehen, mit denen jeweils der andere Pol eines zugeordneten Kompensationskondensators $C_{komp1}$, ..., $C_{kompN}$ entweder in einem ersten Schaltzustand gegen das Bezugspotential oder Massepotential oder in einem zweiten Schaltzustand gegen die Ausgangsspannung des Inverters INV, die gegenüber der Betriebsspannung invers und proportional zu dieser ist, schaltbar ist.

Zwischen dem einen Pol eines jeden Kompensationskondensators $C_{komp1}$ bis $C_{kompN}$ und dem zweiten Umschalter S2 liegt eine entsprechende Mehrzahl N von fünften Schaltern $S5_1$, ..., $S5_N$. Eine Schaltersteuerung SS1, SS2 aktiviert je einen der ersten und dritten Umschalter abhängig von dem Ausgangssignal der Pulserzeugungsschaltung P und schaltet die übrigen der ersten und dritten Umschalter in den ersten Schaltzustand. Ferner schließt sie den entsprechenden vierten und fünften Schalter und läßt die übrigen vierten und fünften Schalter geöffnet.

Bei der alternativen Schaltung gemäß Fig. 7 ist jeder Kompensationskondensator $C_{komp1}$ bis $C_{kompN}$ mit einem Pol gegen Masse geschaltet. Der andere Pol eines jeden Kompensationskondensators $C_{komp1}$ bis $C_{kompN}$ ist mittels eines zugeordneten dritten Umschalters $S3_1$ bis $S3_N$ in einem ersten Schaltzustand mit dem anderen Pol des zugeordneten, zu messenden Kondensators $C_{x1}$ bis $C_{xN}$ oder in einem zweiten Schaltzustand mit der Betriebsspannung $U_B$ verbindbar.

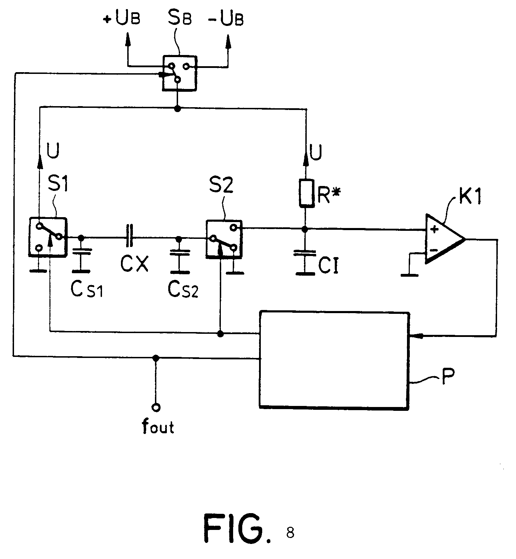

Fig. 8 zeigt eine Abwandlung des in Fig. 2 gezeigten Kapazitäts-Frequenz-Wandlers, wobei die Ausgestaltung nach Fig. 8 zur gleichspannungs-freien Messung geeignet ist. Diejenigen Schaltungsteile, die mit gleichen Bezugszeichen bezeichnet sind, stimmen mit der Schaltung gemäß Fig. 2 überein, so daß auf deren erneute Erläuterung verzichtet werden kann.

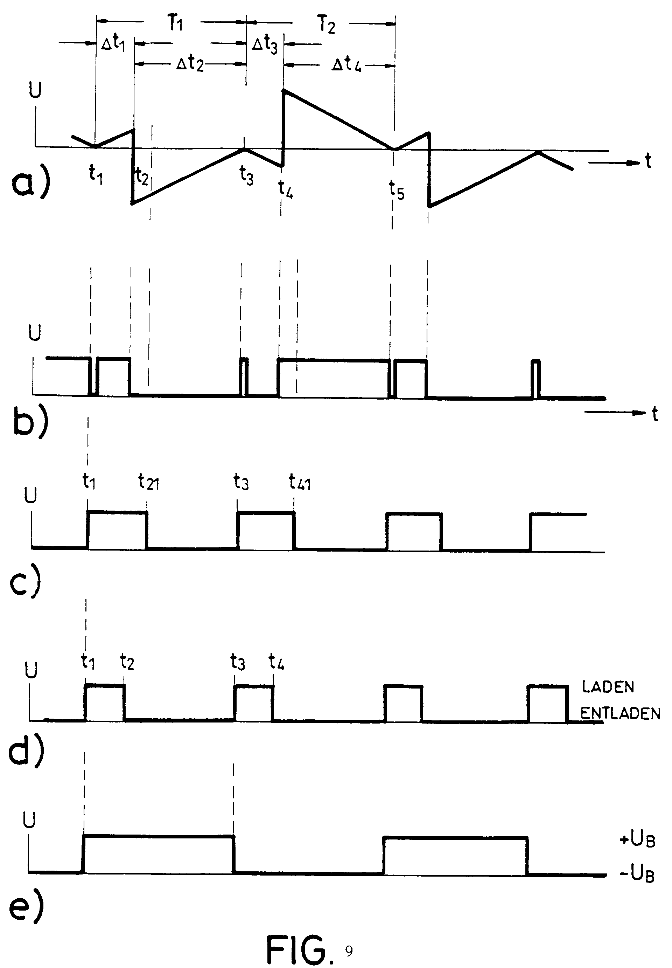

Wie in Fig. 8 gezeigt ist, ist der erste Umschalter S1 in seinem in der Fig. 8 gezeigten zweiten Schaltzustand nicht direkt mit der Betriebsspannung verbunden, wie dies bei der Ausführungsform gemaß Fig. 2 der Fall ist, sondern mit einer Schalteinheit $S_B$ gekoppelt. Gleichfalls ist der von dem weiteren Kondensator $C_I$ abgewandte Anschluß des Widerstandes R*, der die Stromquelleneinrichtung bildet, ebenfalls nicht mit der Betriebsspannung $U_B$ verbunden, sondern ebenfalls an die Schalteinheit $S_B$ angeschlossen. Wie gezeigt ist, verbindet die Schalteinheit $S_B$ somit einen Kontakt des ersten Umschalters $S_1$ sowie den dem weiteren Kondensator $C_I$ abgewandten Anschluß des Widerstandes R* in ihrem ersten Schaltzustand mit einem zweiten Potential, das die Betriebsspannung sein kann, und in ihrem zweiten Schaltzustand mit einem zu dem zweiten Potential inversen Potential, das die inverse Betriebsspannung sein kann. Die inverse Betriebsspannung kann aus der Betriebsspannung durch Verwendung eines Inverters gewonnen werden. Der Ausgang des Kapazitäts-Frequenz-Wandlers wird im Gegensatz zu der Ausführungsform gemäß Fig. 2 nicht durch den Komparatorausgang gebildet, sondern durch einen weiteren Steuerausgang der Pulserzeugungsschaltung P, deren Funktion später unter Bezugnahme auf Fig. 9 näher erläutert wird. Die Funktionsweise der in Fig. 8 gezeigten Schaltung sowie die Funktionsweise der Pulserzeugungsschaltung P gemäß Fig. 4 wird nachfolgend unter Bezugnahme auf die Fig. 9a bis 9e näher erläutert. Zum Zeitpunkt t1 wechselt das Ausgangssignal des Komparators K1 sein Potential, wie dies in Fig. 9b gezeigt ist. Dies löst folgende Vorgänge aus:

- Die Einflußnahme des Komparatorausgangssignales auf die Impulserzeugungsschaltung P wird für die Zeitspanne $t_{21}$-t gesperrt. Es beginnt die Integrationszeitdauer Delta $t_1$. Die Schalteinheit $S_B$ schaltet die dem ersten Schalter sowie dem Widerstand R* zugeführte Betriebsspannung auf $+U_B$ um.
- Der erste und zweite Umschalter S1, S2 werden in ihre in Fig. 8 gezeigte Stellung umgeschaltet, welche dem zweiten Schaltzustand dieser Umschalter entspricht. Hierdurch wird ein Laden des Kondensators $C_x$ an der Betriebsspannung $U_B$ bewirkt.

Innerhalb der Zeitspanne Delta $t_1$ wird der Kondensator $C_x$ in der in Fig. 8 gezeigten Schalterstellung auf $+U_B$ geladen. Ebenfalls wird der weitere Kondensator $C_I$ über den Widerstand R* geladen, wie dies in Fig. 9a gezeigt ist.

Wenn die innerhalb der Pulserzeugungsschaltung P festgelegte Zeitdauer Delta $t_1$ abgelaufen ist, werden die Umschalter S1, S2 in ihren ersten Schaltzustand umgeschaltet, wodurch die Kapazität $C_x$ zu dem weiteren Kondensator $C_I$ parallel geschaltet wird. Dadurch springt die Spannung an dem weiteren Kondensator $C_I$ in das Negative, wie dies in Fig. 9a gezeigt ist.

Innerhalb der Zeitdauer Delta $t_2$ werden die Kapazitäten $C_I$ und $C_x$ bis zu dem Bezugspotential Masse über den Widerstand R* geladen.

Innerhalb der in der Pulserzeugungsschaltung P festgelegten Zeitspanne $t_{21}$-$t_1$ hat das Komparatorausgangssignal keinen Einfluß auf die Abläufe innerhalb der Schaltung. Die Zeitspanne ist so bemessen, daß nach dem Zeitpunkt $t_2$ der Komparatorausgang (siehe Fig. 9b) genügend Zeit hat, um sicher auf dem niedrigen Potential zu sein.

Nach dem Zeitpunkt $t_{21}$ wird die Komparatorausgangsspannung zur Steuerung der Pulserzeugungsschaltung P wieder freigegeben.

Zum Zeitpunkt $t_3$ schaltet der Komparatorausgang. Hierdurch werden folgende Vorgänge ausgelöst:

- Die Einflußnahme des Komparatorausgangssignales wird während der Zeitspanne $(t_{41}-t_3)$ gesperrt. (Siehe Schraffur in Fig. 9c).
- Die Schalteinheit $S_B$ schaltet in ihrem zweiten Schaltzustand um, d.h. sie schaltet auf die negative Betriebsspannung $U_B$.
- Die Umschalter S1, S2 werden in ihren anderen Schaltzustand geschaltet, um den Kondensator $C_x$ auf den Wert $-U_B$ zu laden. Der Spannungsverlauf zum Ansteuern der Umschalter S1, S2 ist in Fig. 9d dargestellt.

Hierbei beginnt die Zeitspanne Delta $t_3$.

Während der Zeitspanne Delta $t_3$ wird der Kondensator $C_x$ an $-U_B$ geladen. Während dieser Zeitspanne wird der weitere Kondensator $C_I$ über den Widerstand R* in Richtung auf die negative Betriebsspannung $-U_B$ entladen.

Die Zeitdauer Delta $t_3$ gleicht der Zeitdauer Delta $t_1$, damit die an dem Kondensator $C_x$ anliegende Meßspannung im zeitliche Mittel zu Null wird, falls die Bedingung erfüllt ist, daß die an die Schalteinheit anliegende positive bzw. invertierte Betriebsspannung $U_B$ den gleichen Absolutwert haben.

Zum Zeitpunkt $t_4$ wird die Kapazität $C_x$ über die beiden Umschalter S1, S2 parallel zu der weiteren Kapazität $C_I$ geschaltet. Dadurch springt die Spannung an dem weiteren Kondensator $C_I$ in das Positive.

Während der Zeitdauer Delta $t_4$ werden die beiden Kapazitäten $C_I$ und $C_x$ über dem Widerstand R* an die negative Betriebsspannung $-U_B$ entladen.

Zum Zeitpunkt $t_{41}$ wird die Komparatorausgangsspannung zur Steuerung der Pulserzeugungsschaltung P nach Ablauf der Zeitspanne $(t_{41}-t_3)$ wieder freigegeben.

Der Zeitpunkt $t_5$ entspricht dem Zeitpunkt $t_1$. Hier durchläuft das Potential an dem weiteren Kondensator $C_I$ das Bezugspotential, so daß der Komparator K1 erneut schaltet und die zu dem Zeitpunkt $t_1$ beschriebenen Vorgänge auslöst.

Nachfolgend wird die Ausgangsfrequenz (siehe Fig. 9e) der beschriebenen Schaltung abgeleitet.

Es wird davon ausgegangen, daß die zu messende Kapazität $C_x$ viel kleiner als die Kapazität des weiteren Kondensators $C_I$ ist, womit in Näherung davon ausgegangen werden kann, daß der weitere Kondensator $C_I$ über R* mit einem konstanten Strom entladen und geladen wird.

Für die Zeitdauer Delta $t_1$ + Delta $t_2$ = $T_1$ gilt somit folgender Zusammenhang:

$$(10) \quad T_1 = \frac{Q_x}{I_R} = \frac{C_x \cdot (+U_B)}{I_R*}$$

Es gilt:

$$(11) \quad I_R* = \frac{+U_B}{R*}$$

Hieraus folgt:

$$(12) \quad T_1 = C_x \cdot R*$$

Für die Zeitdauer Delta $t_3$ + Delta $t_4$ = $T_2$ gilt:

$$(13) \quad T_2 = \frac{Q_x}{I_R^*} = \frac{C_x \, (-U_B)}{I_R^*}$$

$$\text{Mit} \quad I_{R^-} = \frac{+U_B}{R^*} \quad \text{folgt:}$$

$$(14) \quad T_2 = C_x \cdot R^*$$

Damit errechnet sich die Ausgangsfrequenz zu

$$(15) \quad f = \frac{1}{2 \cdot R^* \cdot C_x}$$

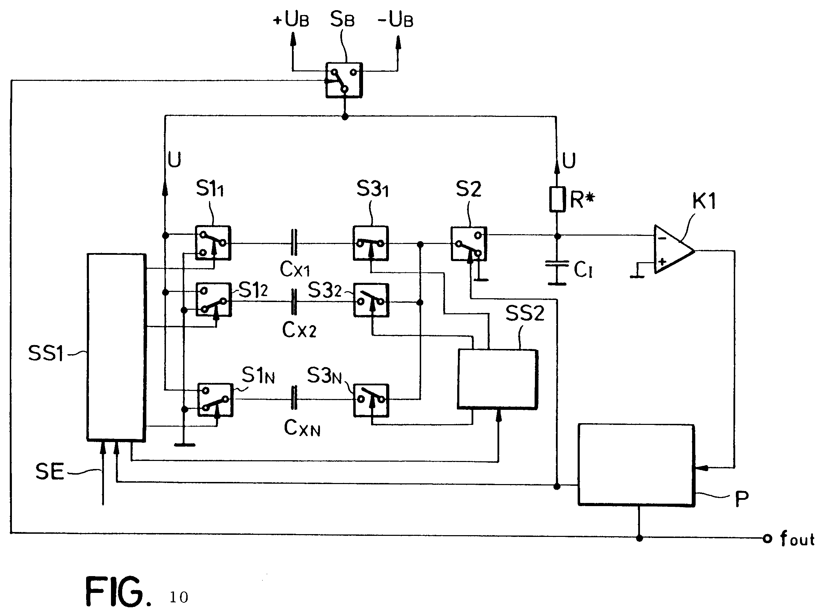

Fig. 10 zeigt eine der Fig. 3 entsprechende Kapazitäts-Frequenz-Wandlerschaltungmit einer Vielzahl von zu messenden Kondensatoren. Wie ersichtlich ist, kann auch bei dieser Schaltung eine gleichspannungs-freie Messung nach dem in Fig. 8 gezeigten Prinzip herbeigeführt werden, indem jeweils ein Pol der ersten Umschalter $S1_1$, ..., $S1_N$ mit der Schalteinheit $S_B$ verbunden ist, an die auch der die Stromquelleneinrichtung bildende Widerstand R* angeschlossen ist, wobei auch hier die Schaltungseinheit sowohl mit der positiven als auch mit der negativen Betriebsspannung $U_B$, -$U_B$ beaufschlagt ist und von der Pulserzeugungsschaltung alternierend umgeschaltet wird.

## Patentansprüche

1. Kapazitäts-Frequenz-Wandler zum Erzeugen eines im wesentlichen rechteckförmigen Wandlerausgangssignales mit einer von der Kapazität eines zu messenden Kondensators abhängigen Pulswiederholfrequenz, gekennzeichnet durch
   - einen ersten Umschalter (S1), mit dem ein Pol des bezüglich seiner Kapazität zu messenden Kondensators ($C_x$) entweder in einem ersten Schaltzustand gegen ein Bezugsspannungspotential oder in einem zweiten Schaltzustand gegen ein erstes Spannungspotential ($U_B$) schaltbar ist;
   - einen zweiten Umschalter (S2), mit dem der andere Pol des bezüglich seiner Kapazität zu messenden Kondensators ($C_x$) entweder in einem ersten Schaltzustand mit einem Knoten (KN) verbindbar oder in einem zweiten Schaltzustand gegen das Bezugsspannungspotential schaltbar ist;
   - einen weiteren Kondensator ($C_I$), der einerseits mit dem Knoten (KN) und andererseits mit einem zweiten Spannungspotential verbunden ist;
   - eine mit dem Knoten (KN) verbundene Stromquelleneinrichtung (R*; R1, R2, R3, K2, T);
   - einen Komparator (K1), dessen erster Eingang mit dem Knoten (KN), dessen zweiter Eingang mit dem Bezugsspannungspotential verbunden ist und dessen Ausgang das Wandlerausgangssignal liefert;
   - eine an den Ausgang des Komparators (K1) angeschlossene Pulserzeugungsschaltung (P) zum Erzeugen je eines Pulses von vorgegebener Dauer (T) bei Auftreten einer Flanke des im wesentlichen rechteckförmigen Wandlerausgangssignales, deren Ausgang mit den den Schaltzustand steuernden Eingängen des ersten und zweiten Umschalters (S1, S2) verbunden ist.

2. Kapazitäts-Frequenz-Wandler nach Anspruch 1, dadurch gekennzeichnet,

daß das erste Spannungspotential einer Betriebsspannung ($U_B$) entspricht.

3. Kapazitäts-Frequenz-Wandler nach Anspruch 1 oder 2, dadurch gekennzeichnet,

daß die Stromquelleneinrichtung eine spannungsgesteuerte Stromquelle (R1, R2, R3, K2, T) ist.

4. Kapazitäts-Frequenz-Wandler nach Anspruch 3, dadurch gekennzeichnet,

daß die Stromquelleneinrichtung einen Spannungsteiler (R1, R2), einen Operationsverstärker (K2), dessen nichtinvertierender Eingang mit dem Spannungsteilerknoten des Spannungsteilers (R1, R2) verbunden ist, einen Transistor (T) und einen Widerstand (R3) aufweist,

daß der Widerstand (R3) zwischen dem ersten Spannungspotential ($U_B$) und der Drainelektrode des Transistors geschaltet ist,

daß das Gate des Transistors (T) mit dem Ausgang des Operationsverstärkers (K2) und dessen Sourceelektrode (S) mit dem Knoten (KN) des Kapazitäts-Frequenz-Wandlers (1) verbunden ist, und

daß der invertierende Eingang des Operationsverstärkers (K2) mit der Drainelektrode (D) des Transistors (T) verbunden ist.

5. Kapazitäts-Frequenz-Wandler nach einem der Ansprüche 1 bis 3, dadurch gekennzeichnet,

daß die Kapazität des zu messenden Kondensators ($C_x$) viel kleiner als die Kapazität des weiteren Kondensators ($C_l$) ist, und

daß die Stromquelleneinrichtung durch einen zwischen den Knoten (KN) und ein drittes Spannungspotential ($U_B$) geschalteten Widerstand (R*) gebildet ist.

6. Kapazitäts-Frequenz-Wandler nach Anspruch 5, dadurch gekennzeichnet,

daß das dritte Spannungspotential dem ersten Spannungspotential ($U_B$) gleicht.

7. Kapazitäts-Frequenz-Wandler nach einem der Ansprüche 1 bis 6, dadurch gekennzeichnet,

daß eine Mehrzahl (N) von bezüglich ihrer Kapazität zu messenden Kondensatoren ($C_{x1}$, ..., $C_{xN}$) vorgesehen sind,

daß eine entsprechende Mehrzahl (N) von ersten Umschaltern ($S1_1$, ..., $S1_N$) mit den Kondensatoren ($C_{x1}$, ..., $C_{xN}$) verbunden sind,

daß eine entsprechende Mehrzahl (N) von dritten Schaltern ($S3_1$, ..., $S3_N$) zwischen den Kondensatoren ($C_{x1}$, ..., $C_{xN}$) und dem zweiten Umschalter (S2) geschaltet sind, und

daß eine Schaltersteuerung (SS1, SS2) einen der ersten Umschalter ($S1_1$, ..., $S1_N$) in Abhängigkeit von dem Ausgangssignal der Pulserzeugungsschaltung (P) aktiviert und die übrigen der ersten Umschalter in den ersten Schaltzustand schaltet und den entsprechenden dritten Schalter ($S3_1$, ..., $S3_N$) schließt sowie die übrigen dritten Schalter öffnet.

8. Kapazitäts-Frequenz-Wandler nach einem der Ansprüche 1 bis 7, dadurch gekennzeichnet,
    - daß ein Kompensationskondensator ($C_{komp}$) vorgesehen ist, der mit seinem einen Pol mit dem anderen Pol des Kondensators ($C_x$) verbunden ist, und
    - daß ein dritter Umschalter (S3) vorgesehen ist, mit dem der andere Pol des Kompensationskondensators ($C_{komp}$) entweder in einem ersten Schaltzustand gegen ein sechstes Potential oder in einem zweiten Schaltzustand gegen ein siebtes Potential ($-kU_B$), das eine gegenüber dem zweiten Potential ($U_B$) inverse Polarität hat, schaltbar ist.

9. Kapazitäts-Frequenz-Wandler nach Anspruch 8, dadurch gekennzeichnet,

daß das erste, dritte, vierte, fünfte und sechste Potential gleich einem Bezugspotential sind.

10. Kapazitäts-Frequenz-Wandler nach Anspruch 8 oder 9, dadurch gekennzeichnet,

daß das zweite Potential einer Betriebsspannung ($U_B$) entspricht, und

daß das siebte Potential proportional zu der inversen Betriebsspannung ist.

11. Kapazitäts-Frequenz-Wandler nach einem der Ansprüche 1 bis 7, dadurch gekennzeichnet,
- daß ein Kompensationskondensator ($C_{komp}$) vorgesehen ist, der mit seinem einen Pol gegen ein achtes Potential geschaltet ist, und
- daß ein dritter Umschalter (S3) vorgesehen ist, mit dem der andere Pol des Kompensationskondensators ($C_{komp}$) entweder in einem ersten Schaltzustand mit dem anderen Pol des Kondensators ($C_x$) oder in einem zweiten Schaltzustand mit dem neunten Potential ($U_B$) verbindbar ist.

12. Kapazitäts-Frequenz-Wandler nach Anspruch 11, dadurch gekennzeichnet,

daß das erste, dritte, vierte, fünfte und achte Potential gleich dem Bezugspotential sind.

13. Kapazitäts-Frequenz-Wandler nach Anspruch 11 oder 12, dadurch gekennzeichnet,

daß das zweite und neunte Potential einer Betriebsspannung ($U_B$) entsprechen.

14. Kapazitäts-Frequenz-Wandler nach einem der Ansprüche 1 bis 13 in Rückbeziehung auf Anspruch 8 oder 11, dadurch gekennzeichnet,

daß eine Mehrzahl (N) von zu messenden Kondensatoren ($C_{x1}$ ..., $C_{xN}$) vorgesehen sind,

daß eine entsprechende Mehrzahl (N) von ersten Umschaltern ($S1_1$, ..., $S1_N$) mit den Kondensatoren ($C_{x1}$, ..., $C_{xN}$) verbunden sind,

daß eine entsprechende Mehrzahl (N) von vierten Schaltern ($S4_1$, ..., $S4_N$) zwischen den Kondensatoren ($C_{x1}$, ..., $C_{xN}$) und dem zweiten Umschalter (S2) geschaltet sind,

daß eine entsprechende Mehrzahl (N) von Kompensationskondensatoren ($C_{komp1}$, ..., $C_{kompN}$) vorgesehen sind,

daß eine entsprechende Mehrzahl (N) von dritten Umschaltern ($S3_1$, ..., $S3_N$) vorgesehen sind, mit denen der andere Pol eines zugeordneten Kompensationskondensators ($C_{komp1}$ ..., $C_{kompN}$) entweder in einem ersten Schaltzustand gegen das sechste Potential oder in einem zweiten Schaltzustand gegen das siebte Potential schaltbar ist, und

daß zwischen dem einen Pol eines jeden Kompensationskondensators ($C_{komp1}$, ..., $C_{kompN}$) und dem zweiten Umschalter (S2) je einer aus einer entsprechenden Mehrzahl (N) von fünften Schaltern ($S5_1$, ..., $S5_N$) angeordnet ist.

15. Kapazitäts-Frequenz-Wandler nach einem der Ansprüche 1 bis 13 in Rückbeziehung auf Anspruch 8 oder 11, dadurch gekennzeichnet,

daß eine Mehrzahl (N) von zu messenden Kondensatoren ($C_{x1}$, ..., $C_{xN}$) vorgesehen sind,

daß eine entsprechende Mehrzahl (N) von ersten Umschaltern ($S1_1$, ..., $S1_N$) mit den Kondensatoren ($C_{x1}$, ..., $C_{xN}$) verbunden sind,

daß eine entsprechende Mehrzahl (N) von vierten Schaltern ($S4_1$, ..., $S4_N$) zwischen den Kondensatoren ($C_{x1}$, ..., $C_xN$) und dem zweiten Umschalter (S2) geschaltet sind,

daß eine entsprechende Mehrzahl (N) von Kompensationskondensatoren ($C_{komp1}$, ..., $C_{kompN}$) vorgesehen sind, und

daß eine entsprechende Mehrzahl (N) von dritten Umschaltern ($S3_1$, ..., $S3_N$) vorgesehen sind, mit denen jeweils der andere Pol von einem der zugeordneten Kompensationskondensatoren ($C_{komp1}$, ..., $C_{kompN}$) entweder in einem ersten Schaltzustand mit dem anderen Pol von einem der zugeordneten Kondensatoren ($C_x$) oder in einem zweiten Schaltzustand mit dem neunten Potential ($U_B$) verbindbar sind.

16. Kapazitäts-Frequenz-Wandler nach Anspruch 14, dadurch gekennzeichnet,

daß eine Schaltersteuerung (SS1, SS2) je einen der ersten und dritten Umschalter ($S1_1$, ..., $S1_N$, $S3_1$, ..., $S3_N$) abhängig von dem Ausgangssignal der Pulserzeugungsschaltung (P) aktiviert und die übrigen der ersten und dritten Umschalter in den ersten Schaltzustand schaltet und den entsprechenden vierten und fünften Schalter ($S4_1$, ..., $S4_N$, $S5_1$, ..., $S5_N$) schließt und die übrigen vierten und fünften Schalter öffnet.

17. Kapazitäts-Frequenz-Wandler nach Anspruch 15, dadurch gekennzeichnet,

daß eine Schaltersteuerung (SS1, SS2) je einen der ersten und dritten Umschalter ($S1_1$, ..., $S1_N$; $S3_1$, ..., $S3_N$) abhängig von dem Ausgangssignal der Pulserzeugungsschaltung (P) aktiviert und die übrigen ersten und dritten Umschalter in den ersten Schaltzustand schaltet und den entsprechenden vierten Schalter ($S4_1$, ..., $S4_N$) schließt sowie die übrigen vierten Schalter öffnet.

18. Kapazitäts-Frequenz-Wandler zum Erzeugen eines im wesentlichen rechteckförmigen Wandlerausgangssignales mit einer von der Kapazität eines zu messenden Kondensators abhängigen Pulswiederholfrequenz, gekennzeichnet durch
   - einen ersten Umschalter (S1), mit dem ein Pol des Kondensators ($C_x$) in einem ersten Schaltzustand gegen ein erstes Potential schaltbar ist;
   - einen zweiten Umschalter (S2), mit dem der andere Pol des Kondensators ($C_x$) entweder in einem ersten Schaltzustand mit einem Knoten (KN) verbindbar oder in einem zweiten Schaltzustand gegen ein drittes Potential schaltbar ist;
   - einen weiteren Kondensator ($C_I$), der einerseits mit dem Knoten (KN) und andererseits mit einem vierten Potential verbunden ist;
   - eine mit dem Knoten (KN) verbundene Stromquelleneinrichtung (R*; R1, R2, R3, K2, T);
   - einen Komparator (K1), dessen erster Eingang mit dem Knoten (KN) und dessen zweiter Eingang mit einem fünften Potential verbunden sind;
   - eine an den Ausgang des Komparators (K1) angeschlossene Pulserzeugungsschaltung (P) zum Erzeugen je eines Pulses von vorgegebener Dauer (T) bei Auftreten einer Flanke des Komparatorausgangssignales, deren Ausgang mit den den Schaltzustand steuernden Eingängen des ersten und zweiten Umschalters (S1, S2) verbunden ist,
   - eine Schalteinheit ($S_B$), die mit dem ersten Umschalter (S1) verbunden ist und in dem zweiten Schaltzustand des ersten Umschalters (S1) den ihr zugewandten Pol des Kondensators ($C_x$) in ihrem ersten Schaltzustand mit einem zweiten Potential und in ihrem zweiten Schaltzustand mit einem zu dem zweiten Potential inversen Potential beaufschlagt,
   - wobei die Schalteinheit ($S_B$) den von der Stromquelleneinrichtung (R*; R1, R2, R3, K2, T) erzeugten Strom dem Knoten (KN) in ihrem ersten Schaltzustand in positiver Richtung und in ihrem zweiten Schaltzustand in negativer Richtung zuführt.

19. Kapazitäts-Frequenz-Wandler nach Anspruch 18, dadurch gekennzeichnet,

daß das erste, dritte, vierte und fünfte Potential gleich einem Bezugspotential sind.

20. Kapazitäts-Frequenz-Wandler nach Anspruch 18 oder 19, dadurch gekennzeichnet,

daß die Stromquelleneinrichtung durch einen zwischen der Schalteinheit ($S_B$) und dem Knoten (KN) geschalteten Widerstand (R*) gebildet ist.

14

FIG.1

FIG. 2

FIG. 3

EP 0 489 259 A2

FIG.4

FIG.5

FIG.6

FIG.7

FIG. 8

FIG. 9

FIG. 10